# FASCICULE DE BREVET EUROPEEN

(11) **EP 3 037 893 B1**
(45) Date de publication et mention de la délivrance du brevet: **28.02.2018**
(21) Numéro de dépôt: 14199602.5
(22) Date de dépôt: 22.12.2014
(51) Int. Cl.: G04B 17/04, B81B 3/00

(54) **Composant micromécanique ou horloger à guidage flexible**
Mikromechanische Komponente oder Uhr mit flexiblem Führungsdraht
Micromechanical or clock component with flexible guidance

(43) Date de publication de la demande: 29.06.2016
(73) Titulaire: Patek Philippe SA Genève, 1204 Genève (CH)
(72) Inventeur: Musy, Jean-Pierre, 1196 Gland (CH)
(74) Mandataire: Micheli & Cie SA

(56) Documents cités:
- EP-A2- 2 037 335
- WO-A1-2011/120180
- CH-A2- 702 576
- CH-A2- 707 778
- US-A1- 2010 214 880

## Description

La présente invention concerne un composant micromécanique ou horloger à guidage flexible.

Des composants horlogers à guidage flexible, du type échappement ou oscillateur, ont été proposés dans les documents EP 2037335, EP 2273323, EP 2645189, WO 2011/120180 et WO 2012/010408. Ces composants comprennent deux parties rigides, à savoir une partie de fixation et une partie mobile, reliées par un système à bras élastiques définissant un axe de rotation virtuel pour la partie mobile par rapport à la partie de fixation. Pour permettre à la partie mobile de pivoter par rapport à la partie de fixation, les bras élastiques se déforment dans un plan perpendiculaire à l'axe de rotation virtuel. A cet effet, la section des bras élastiques est mince dans ledit plan perpendiculaire à l'axe de rotation virtuel et épaisse parallèlement à l'axe de rotation virtuel. L'avantage d'un tel guidage flexible est qu'il supprime les frottements et les jeux de pivotement.

Les bras élastiques d'un composant à guidage flexible constituent toutefois une zone de faiblesse qui peut amener la partie mobile à s'affaisser sous l'effet de son poids par rapport à la partie de fixation, notamment lors de chocs, en déformant les bras parallèlement à l'axe de rotation virtuel. Lorsqu'un tel affaissement se produit, la partie mobile peut perdre le contact avec le composant partenaire avec lequel il coopérait et/ou peut venir toucher d'autres composants, par exemple la platine ou un pont. Le fonctionnement du mouvement horloger en est alors bien entendu affecté et des pièces dudit mouvement peuvent être endommagées. Pour résoudre ce problème, on peut encore augmenter la dimension des bras élastiques parallèlement à l'axe de rotation virtuel, mais ceci accroît l'encombrement du composant et n'est pas toujours possible compte tenu de la place disponible.

On connaît aussi dans l'état de la technique les documents US 2010/0214880, CH 707778 et CH 702576. Le document US 2010/0214880 décrit un composant micromécanique en silicium pour mécanisme horloger, recouvert sur toute sa surface d'une couche d'oxyde de silicium d'épaisseur cinq fois supérieure à l'épaisseur de l'oxyde de silicium natif pour augmenter sa résistance mécanique. Le document CH 707778 décrit un spiral compensateur pour résonateur balancier-spiral compensé thermiquement, le spiral compensateur comprenant une âme formée d'au moins un matériau non métallique et partiellement revêtue d'au moins une couche qui est stable à l'humidité afin de rendre le spiral compensateur moins sensible aux variations climatiques. Enfin, le document CH 702576 décrit une pièce micromécanique comprenant une âme en silicium au moins partiellement revêtue d'une première couche comprenant du diamant, ainsi qu'une deuxième couche possédant des propriétés tribologiques complémentaires à celles de la première couche.

La présente invention vise à remédier ou au moins atténuer l'inconvénient susmentionné des composants à guidage flexible et propose à cette fin un composant micromécanique ou horloger à
guidage flexible comprenant des première et deuxième parties rigides reliées par un système à bras élastiques agencé pour guider un déplacement de la deuxième partie rigide par rapport à la première partie rigide dans un plan déterminé, caractérisé en ce que l'un au moins des bras élastiques comprend une âme et un revêtement fait dans un matériau ayant un module d'élasticité supérieur au matériau dans lequel est faite l'âme, et en ce que l'âme porte le revêtement seulement sur ses deux faces, ou l'une de ses deux faces, qui sont parallèles au plan déterminé.

Comme l'âme ne porte pas le revêtement sur ses faces qui sont perpendiculaires au plan déterminé, la rigidité des bras élastiques parallèlement au plan déterminé peut rester faible, permettant ainsi auxdits bras d'exercer pleinement leur fonction, tandis que leur rigidité perpendiculairement au plan déterminé peut être élevée voire très élevée, ceci dans un encombrement donné du composant.

Dans des modes de réalisation de l'invention, le module d'élasticité du matériau dans lequel est fait le revêtement est au moins deux fois plus grand que le module d'élasticité du matériau dans lequel est faite l'âme.

Dans des modes de réalisation de l'invention, le revêtement est fait dans l'un des matériaux suivants : diamant, carbure, nitrure, céramique, cermet, carbone amorphe.

L'âme peut, elle, être faite dans l'un des matériaux suivants : métal, alliage métallique, silicium, verre métallique.

L'épaisseur du revêtement peut être comprise entre 1 et 30 µm.

Avantageusement, le revêtement est présent aussi sur l'une au moins des parties rigides. Plus précisément, le revêtement peut être présent sur chaque bras élastique et aussi sur chaque partie rigide.

Ledit déplacement peut être une rotation de la deuxième partie rigide par rapport à la première partie rigide autour d'un axe de rotation virtuel. Dans ce cas, les bras élastiques, ou au moins deux d'entre eux, peuvent se croiser. En variante, le système à bras élastiques peut former un pivot RCC.

Dans des variantes, ledit déplacement peut être une translation de la deuxième partie rigide par rapport à la première partie rigide.

Typiquement, l'une des parties rigides est une partie de fixation du composant et l'autre partie rigide est une partie mobile. La partie de fixation peut elle-même être en plusieurs parties séparées, destinées à être fixées à un même support ou à des supports différents.

Typiquement, le composant micromécanique ou horloger selon l'invention est, ou comprend, une bascule, un levier, un oscillateur ou une ancre d'échappement.

La présente invention propose en outre un procédé de fabrication d'un composant micromécanique ou horloger tel que défini ci-dessus, caractérisé en ce que l'on forme le revêtement sur au moins une des faces principales d'une plaquette et en ce que l'on grave la plaquette ainsi revêtue pour former le composant.

La présente invention propose enfin un procédé de fabrication d'une pièce destinée à faire partie d'un composant micromécanique ou horloger tel que défini ci-dessus, la pièce comprenant au moins l'un des bras élastiques du composant, caractérisé en ce que l'on forme le revêtement sur au moins une des faces principales d'une plaquette et en ce que l'on grave la plaquette ainsi revêtue pour former la pièce.

D'autres caractéristiques et avantages de la présente invention apparaîtront à la lecture de la description détaillée suivante faite en référence aux dessins annexés dans lesquels :
- les figures 1 à 3 montrent respectivement en vue plane de dessus, en perspective de dessus et en perspective de dessous un composant horloger selon l'invention ;
- les figures 4 à 6 montrent respectivement en vue plane de dessus, en perspective de dessus et en perspective de dessous une première pièce faisant partie du composant horloger selon l'invention ;
- les figures 7 à 9 montrent respectivement en vue plane de dessus, en perspective de dessus et en perspective de dessous une deuxième pièce faisant partie du composant horloger selon l'invention ;
- les figures 10 et 11 montrent schématiquement, respectivement en vue de côté et en coupe transversale, un bras élastique faisant partie du composant horloger selon l'invention ; et
- la figure 12 est vue en coupe schématique d'une plaquette (« wafer ») à partir de laquelle le composant horloger selon l'invention peut être fabriqué ; sur cette figure, l'épaisseur d'un revêtement couvrant la plaquette a été exagérée.

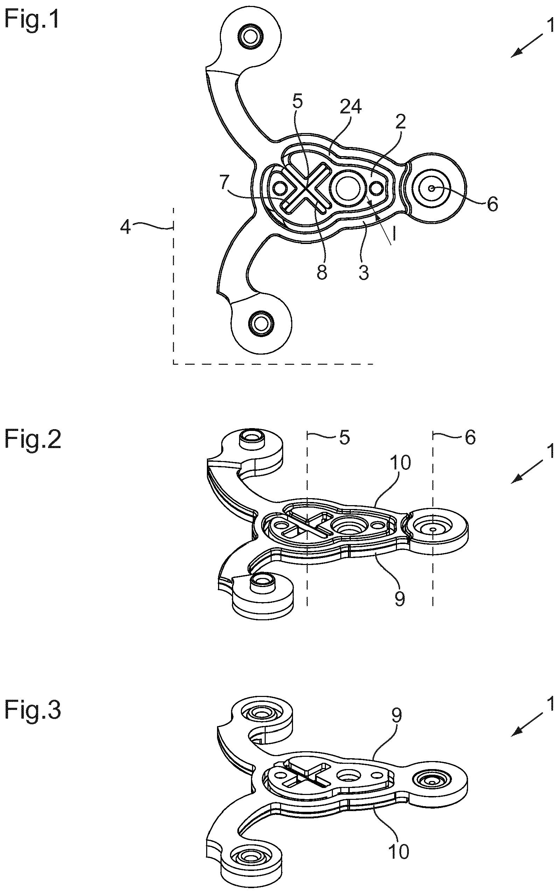

En référence aux figures 1 à 3, un composant horloger à guidage flexible 1 selon un mode de réalisation particulier de l'invention, destiné à faire partie d'un mouvement horloger, plus particulièrement d'un mouvement de montre-bracelet, comprend une partie centrale de fixation 2 et une partie périphérique mobile 3, toutes deux rigides. La partie périphérique mobile 3 entoure la partie centrale de fixation 2. La partie centrale de fixation 2 sert à monter le composant horloger 1 sur un support 4 (représenté schématiquement), support qui peut être fixe (par exemple la platine d'un mouvement) ou mobile. La partie périphérique mobile 3 est pivotante par rapport à la partie centrale de fixation 2 et au support 4 autour d'un axe de rotation virtuel 5 défini par un système élastique. Ainsi, aucun axe physique n'est utilisé pour faire tourner la partie périphérique mobile 3. Cette dernière peut donc pivoter sans frottements et sans jeux.

Dans l'exemple illustré, le composant horloger 1 est une bascule, plus précisément une bascule d'embrayage portant une roue d'embrayage (non représentée). La roue d'embrayage pivote autour d'un axe 6 qui est parallèle à l'axe de rotation virtuel 5 mais distinct de ce dernier. Cette bascule d'embrayage est destinée à être utilisée, par exemple, dans un mécanisme de chronographe.

Le système élastique définissant l'axe de rotation virtuel 5 comprend deux bras élastiques 7, 8 qui relient la partie centrale de fixation 2 et la partie périphérique mobile 3 et qui se croisent. Dans l'exemple illustré, les bras 7, 8 sont sous la forme de lames dites « croisées séparées », c'est-à-dire de lames qui se croisent dans deux plans différents parallèles au plan du composant 1 (plan de la figure 1). Contrairement aux systèmes dits « à lames croisées non séparées », les deux bras 7, 8 ne se croisent donc pas physiquement. Cet agencement des bras 7, 8 diminue d'un facteur 4 la raideur du système élastique par rapport aux systèmes à lames croisées non séparées. L'axe de rotation virtuel 5 correspond sensiblement à la droite qui est perpendiculaire au plan du composant 1 et qui traverse les deux bras 7, 8. Cet axe de rotation virtuel 5 n'est pas complètement fixe pendant les mouvements de la partie périphérique mobile 3. Il est connu dans la théorie qu'il existe une translation parasite de l'axe de rotation qui augmente avec l'angle de rotation. Cette translation parasite peut être annulée par un agencement de lames connu, par exemple celui décrit dans la demande de brevet WO 2011/120180.

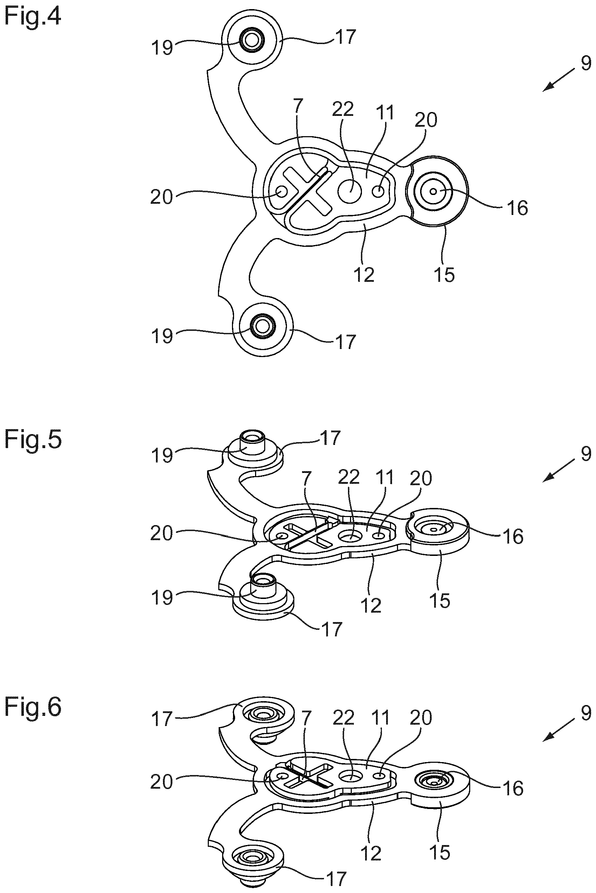

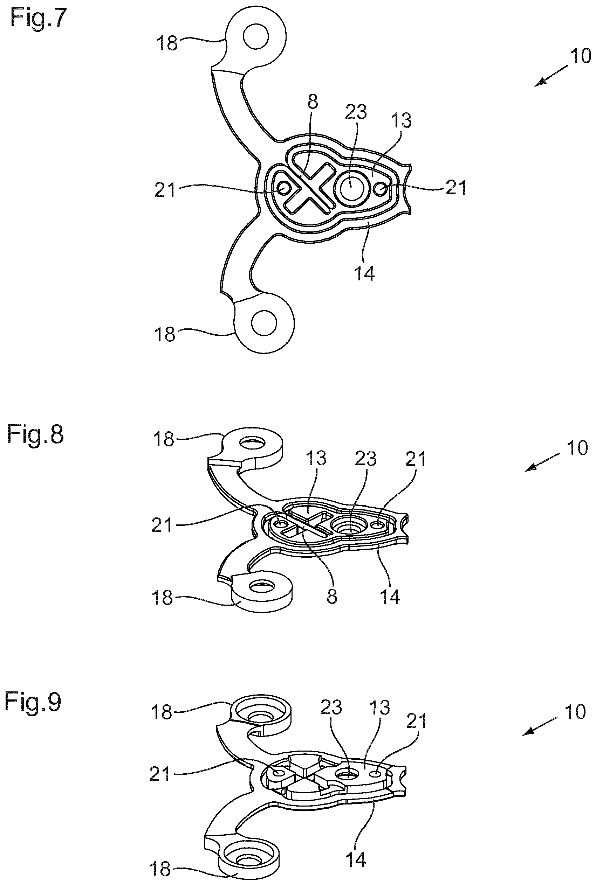

Comme cela est visible aux figures 2 et 3, le composant horloger 1 comprend deux pièces monolithiques 9, 10 assemblées l'une à l'autre. Les pièces 9, 10 sont plates et superposées dans la direction de l'axe de rotation virtuel 5. La pièce inférieure 9 (cf. figures 4 à 6) comprend une partie centrale 11 et une partie périphérique 12 reliées l'une à l'autre par le bras élastique 7. La partie centrale 11 est plus basse que la partie périphérique 12, ou comprend une partie qui s'étend au-dessous du plan de la partie périphérique 12, pour pouvoir s'appuyer sur le support 4 en laissant la partie périphérique 12 sans contact avec ce support 4. En variante, le support 4 peut comporter une partie surélevée sur laquelle peut s'appuyer la partie centrale 11 de la pièce inférieure 9 pour éviter un contact entre la partie périphérique 12 et ledit support 4. La pièce supérieure 10 (cf. figures 7 à 9) comprend une partie centrale 13 et une partie périphérique 14 reliées l'une à l'autre par le bras élastique 8. La partie centrale 13 a une plus grande épaisseur que la partie périphérique 14, ou comprend une partie qui s'étend au-dessous du plan de la partie périphérique 14, pour pouvoir s'engager dans l'ouverture centrale de la partie périphérique 12 et contre la partie centrale 11 de la pièce inférieure 9. La partie centrale 11 et la partie périphérique 12 de la pièce inférieure 9 ont la même forme que la partie centrale 13 et la partie périphérique 14 de la pièce supérieure 10, respectivement. Les pièces inférieure et supérieure 9, 10 peuvent ainsi être plaquées l'une contre l'autre pour former le composant 1. La pièce inférieure 9 comporte toutefois un prolongement 15 qui forme un palier recevant une pierre 16 dans laquelle pivote un premier pivot de l'arbre de la roue d'embrayage. En variante, ce prolongement 15 qui reçoit la pierre 16 pourrait faire partie de la pièce supérieure 10.

Les parties périphériques 12, 14 définissent chacune deux oreilles 17, 18 percées chacune d'un trou. Le trou de chaque oreille 17 de la pièce inférieure 9 est aligné avec le trou de l'oreille 18 correspondante de la pièce supérieure 10 mais a un diamètre plus petit. Des tubes 19 sont fixés, par exemple chassés, dans les trous des oreilles 17 de la pièce inférieure 9 et sont reçus dans les trous des oreilles 18 de la pièce supérieure 10 de manière à positionner et solidariser en rotation les deux pièces 9, 10 l'une par rapport à l'autre. Les tubes 19 sont taraudés pour permettre le vissage d'un pont sur le composant 1, pont qui comprend le palier pour le deuxième pivot de l'arbre de la roue d'embrayage. La partie centrale 11 de la pièce inférieure 9 est percée de trous 20 qui sont alignés avec des trous correspondants 21 de la partie centrale 13 de la pièce supérieure 10. Ces trous 20, 21 permettent à des goupilles fixées au support 4 de traverser les pièces inférieure et supérieure 9, 10 pour positionner le composant 1 sur le support 4. Un autre trou 22 de la pièce inférieure 9 aligné avec un trou 23 de la pièce supérieure 10 permet à une vis de traverser les pièces inférieure et supérieure 9, 10. Cette vis est vissée dans le support 4 et plaque le composant 1 contre ledit support 4.

On voit qu'ainsi les pièces inférieure et supérieure 9, 10 sont fixées l'une à l'autre axialement en étant ensemble fixées au support 4. En variante, les pièces 9, 10 pourraient être directement fixées l'une à l'autre, par exemple par collage ou soudage, avant d'être montées sur le support 4.

Ainsi assemblées, les pièces inférieure et supérieure 9, 10 ont leurs parties centrales respectives 11, 13 qui sont solidaires pour former ensemble la partie centrale de fixation 2 du composant 1 et leurs parties périphériques 12, 14 qui sont solidaires pour former ensemble la partie périphérique mobile 3 du composant 1. Grâce à ses deux pièces assemblées 9, 10, chacune comprenant l'un des bras élastiques 7, 8, le composant horloger 1 est relativement facile à fabriquer et peut présenter un faible encombrement.

Dans des variantes, les fonctions des parties centrale 2 et périphérique 3 pourraient être inversées. Ainsi, la partie périphérique 3 pourrait être une partie de fixation servant à monter le composant horloger sur un support, tandis que la partie centrale 2 pourrait être une partie active, mobile par rapport au support.

Comme visible à la figure 1, l'espace vide 24 entre la partie centrale de fixation 2 et la partie périphérique mobile 3 qui l'entoure a une largeur l qui permet une rotation de la partie périphérique mobile 3 par rapport à la partie centrale de fixation 2 dans une certaine plage. A partir d'une certaine amplitude de rotation, dans un sens ou dans l'autre, la partie périphérique mobile 3 bute contre la partie centrale de fixation 2 pour limiter la déformation des bras élastiques 7, 8. La largeur l est choisie suffisamment petite pour que la limite élastique des bras 7, 8 ne puisse pas être dépassée. Ainsi, les bras 7, 8 ne peuvent pas se déformer plastiquement ni se rompre. En variante, pour limiter la déformation des bras élastiques 7, 8, on pourrait prévoir une butée fixée au support 4 et contre laquelle pourrait venir s'appuyer la partie périphérique mobile 3.

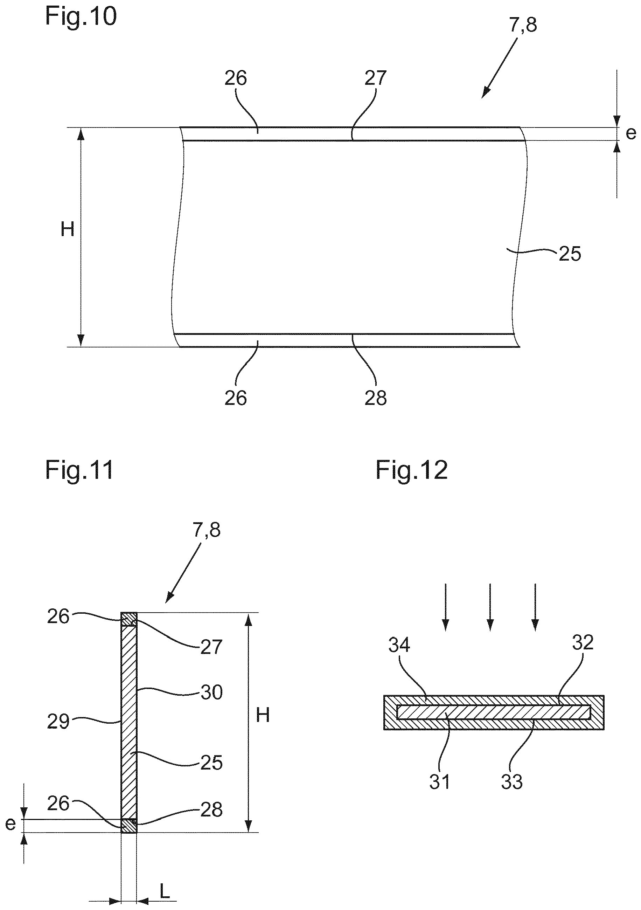

Comme il ressort de ce qui précède, la partie périphérique mobile 3 peut pivoter par rapport à la partie centrale de fixation 2 autour de l'axe de rotation virtuel 5 par une déformation ou flexion des bras élastiques 7, 8 dans des plans respectifs parallèles au plan du composant 1 et perpendiculaires à l'axe de rotation virtuel 5. Il est important que les bras 7, 8 ne se déforment pas, ou se déforment le moins possible, parallèlement à l'axe de rotation virtuel 5. A cet effet, selon l'invention, les bras élastiques 7, 8 ont une structure composite telle qu'illustrée aux figures 10 et 11. Chaque bras 7, 8 comprend une âme 25 et un revêtement ou couche 26. Le revêtement 26 est situé seulement sur les faces supérieure et inférieure 27, 28 de l'âme 25, c'est-à-dire les faces qui sont perpendiculaires à l'axe de rotation virtuel 5, ou seulement sur l'une de ces faces 27, 28. Les autres faces de l'âme 25, à savoir les faces latérales 29, 30 parallèles à l'axe de rotation virtuel 5, ne sont pas couvertes par le revêtement 26. La section de l'âme 25 a typiquement une forme rectangulaire ou carrée. La hauteur H de chaque bras 7, 8, c'est-à-dire sa dimension parallèlement à l'axe de rotation virtuel 5, est de préférence supérieure à sa largeur L. Typiquement, la hauteur H est d'environ 250 µm et la largeur L est comprise entre 10 et 100 µm, de préférence entre 35 et 50 µm.

Le revêtement 26 est fait en un matériau dont le module d'élasticité ou module de Young est supérieur à celui du matériau dans lequel est faite l'âme 25. Ainsi, la rigidité des bras élastiques 7, 8 dans la direction de l'axe de rotation virtuel 5 est augmentée par rapport à des bras de mêmes dimensions mais réalisés uniquement dans le matériau de l'âme 25. On peut donc obtenir un composant horloger 1 dont la partie périphérique mobile 3 reste sensiblement parfaitement dans son plan de fonctionnement et ne s'incline pas par rapport à la partie centrale de fixation 2, sans qu'il soit nécessaire de donner aux bras élastiques 7, 8 une grande hauteur H. En particulier, dans le cas de la bascule d'embrayage illustrée aux figures 1 à 3, la partie périphérique mobile 3 ne s'incline pas sous l'effet du poids de la roue d'embrayage, même lors de chocs. Comme le revêtement 26 ne couvre pas les faces latérales 29, 30 de l'âme 25, la rigidité des lames élastiques 7, 8 dans le plan du composant 1 n'est que très peu augmentée. Cette rigidité dans le plan du composant 1 peut d'ailleurs être maintenue constante en diminuant la largeur L des bras 7, 8.

Dans des exemples de réalisation, le module d'élasticité du matériau du revêtement 26 est supérieur à 300 GPa, de préférence supérieur à 400 GPa, voire à 600 GPa, voire encore à 1000 GPa, et celui du matériau de l'âme 25 est inférieur à 250 GPa, voire à 200 GPa, voire encore à 100 GPa. Le module d'élasticité du matériau du revêtement 26 est typiquement au moins deux fois plus grand que le module d'élasticité du matériau de l'âme 25. La hauteur ou épaisseur e du revêtement 26 est par exemple comprise entre 1 et 30 µm.

Le revêtement 26 peut être situé uniquement sur les bras élastiques 7, 8 ou, en variante, aussi sur le reste du composant 1. Selon les matériaux utilisés, le revêtement 26 peut être formé sur l'âme de chaque bras 7, 8 ou du composant 1 dans son entier par une technique de dépôt, ou être collé ou soudé à ladite âme, ou être formé par tout autre procédé approprié.

L'âme des pièces inférieure et supérieure 9, 10 et de leurs bras 7, 8 respectifs est par exemple faite dans l'un des matériaux suivants : silicium, verre métallique, métal tel qu'acier, titane, or ou nickel, alliage métallique tel que nickel-phosphore ou autre alliage à base de nickel. Selon le matériau choisi, l'âme des pièces inférieure et supérieure 9, 10 peut être réalisée par usinage au fil, électroformage (par exemple LIGA), gravure (par exemple DRIE) ou moulage. Dans des variantes, l'âme elle-même peut avoir une structure composite. Le revêtement 26 peut être fait dans différents matériaux tels que le diamant, un carbure (carbure de tungstène ou de silicium par exemple), un nitrure, l'alumine ou autre céramique, le cermet ou le carbone amorphe DLC (« Diamond-Like Carbon »). Pour le revêtement 26, on peut choisir un matériau qui, en plus d'augmenter la rigidité dans la direction de l'axe de rotation virtuel 5, augmente la résistance mécanique du composant 1. Selon des exemples de réalisation préférentiels, l'âme est en acier, titane ou silicium et le revêtement est en diamant.

Dans le cas d'une âme en silicium et d'un revêtement en diamant, on peut partir d'une plaquette de silicium 31 (cf. figure 12) et couvrir toute sa surface, ou au moins l'une de ses deux faces principales 32, 33, d'une couche de diamant 34 par une technique de dépôt, puis graver la plaquette 31, 34 perpendiculairement aux faces 32, 33 pour former les pièces inférieure et supérieure 9, 10. Les faces supérieure et/ou inférieure des pièces 9, 10, y compris des bras élastiques 7, 8, seront ainsi en diamant tandis que les flancs des pièces 9, 10, y compris les faces latérales 29, 30 des bras élastiques 7, 8, ne seront pas couvertes par le diamant. Les pièces 9, 10 sont ensuite détachées de la plaquette puis assemblées. En variante, les pièces 9, 10 peuvent être réalisées à partir de plaquettes différentes puis assemblées. Dans d'autres variantes, on peut graver l'âme du composant dans une plaquette de silicium puis déposer le revêtement sur ses faces supérieure et/ou inférieure. On peut aussi déposer le revêtement sélectivement sur les bras élastiques 7, 8. Tous ces procédés peuvent bien entendu être mis en oeuvre avec d'autres matériaux que le silicium et le diamant.

Il va de soi que la présente invention n'est pas limitée au composant horloger 1 tel qu'illustré aux figures 1 à 3 mais qu'elle peut s'appliquer à tout type de composant horloger à guidage flexible, par exemple à d'autres types de bascule ou levier qu'une bascule d'embrayage, tels que des bloqueurs, des palpeurs, des marteaux ou des correcteurs, à des oscillateurs servant de base de temps (c'est-à-dire remplissant la fonction d'un balancier-spiral) ou à des ancres d'échappement. L'agencement des bras élastiques n'est pas nécessairement du type à lames croisées séparées. Les bras élastiques peuvent en effet être des lames croisées non séparées (lames dans un même plan) ou former un pivot à centre de rotation déporté dit « RCC » (Remote Center Compliance), en particulier un pivot RCC à deux lames ou à quatre cols. Au lieu de constituer un pivot flexible, les bras élastiques peuvent former un guidage flexible en translation et être par exemple parallèles entre eux et perpendiculaires à la direction de translation.

Notamment lorsque les bras élastiques sont dans un même plan, le composant peut être réalisé en une seule pièce obtenue par gravure d'une plaquette couverte par le revêtement.

Par ailleurs, le nombre de bras élastiques peut être supérieur à deux. Par exemple, le composant horloger 1 pourrait comprendre trois, quatre ou plus de pièces superposées du type des pièces 7, 11, 12 et 8, 13, 14.

Les bras élastiques peuvent être rectilignes, comme les bras 7, 8 dans l'exemple illustré, mais ils peuvent aussi être courbes et avoir diverses formes.

Enfin, la présente invention peut s'appliquer à des domaines de la micromécanique non horlogers.

## Revendications

1. Composant micromécanique ou horloger à guidage flexible comprenant des première et deuxième parties rigides (2, 3) reliées par un système à bras élastiques (7, 8) agencé pour guider un déplacement de la deuxième partie rigide (3) par rapport à la première partie rigide (2) dans un plan déterminé, **caractérisé en ce que** l'un au moins des bras élastiques (7, 8) comprend une âme (25) et un revêtement (26) fait dans un matériau ayant un module d'élasticité supérieur au matériau dans lequel est faite l'âme, et **en ce que** l'âme (25) porte le revêtement (26) seulement sur ses deux faces (27, 28), ou l'une de ses deux faces (27, 28), qui sont parallèles au plan déterminé.

2. Composant selon la revendication 1, **caractérisé en ce que** le module d'élasticité du matériau dans lequel est fait le revêtement est au moins deux fois plus grand que le module d'élasticité du matériau dans lequel est faite l'âme.

3. Composant selon la revendication 1 ou 2, **caractérisé en ce que** le revêtement (26) est fait dans l'un des matériaux suivants : diamant, carbure, nitrure, céramique, cermet, carbone amorphe.

4. Composant selon l'une quelconque des revendications 1 à 3, **caractérisé en ce que** l'âme (25) est faite dans l'un des matériaux suivants : métal, alliage métallique, silicium, verre métallique.

5. Composant selon l'une quelconque des revendications 1 à 4, **caractérisé en ce que** l'épaisseur (e) du revêtement (26) est comprise entre 1 et 30 µm.

6. Composant selon l'une quelconque des revendications 1 à 5, **caractérisé en ce que** le revêtement (26) est présent aussi sur l'une au moins des parties rigides (2, 3).

7. Composant selon la revendication 6, **caractérisé en ce que** le revêtement (26) est présent sur chaque bras élastique (7, 8) et aussi sur chaque partie rigide (2, 3).

8. Composant selon l'une quelconque des revendications 1 à 7, **caractérisé en ce que** ledit déplacement est une rotation de la deuxième partie rigide (3) par rapport à la première partie rigide (2) autour d'un axe de rotation virtuel (5).

9. Composant selon la revendication 8, **caractérisé en ce que** les bras élastiques (7, 8), ou au moins deux d'entre eux, se croisent.

10. Composant selon la revendication 8, **caractérisé en ce que** le système à bras élastiques forme un pivot RCC.

11. Composant selon l'une quelconque des revendications 1 à 7, **caractérisé en ce que** ledit déplacement est une translation de la deuxième partie rigide (3) par rapport à la première partie rigide (2).

12. Composant selon l'une quelconque des revendications 1 à 11, **caractérisé en ce qu'**il est, ou comprend, une bascule, un levier, un oscillateur ou une ancre d'échappement.

13. Procédé de fabrication d'un composant micromécanique ou horloger selon l'une quelconque des revendications 1 à 12, **caractérisé en ce que** l'on forme le revêtement (34) sur au moins une des faces principales (32, 33) d'une plaquette (31) et **en ce que** l'on grave la plaquette ainsi revêtue pour former le composant.

14. Procédé de fabrication d'une pièce (9 ; 10) destinée à faire partie d'un composant micromécanique ou horloger (1) selon l'une quelconque des revendications 1 à 12, la pièce (9 ; 10) comprenant au moins l'un des bras élastiques (7, 8) du composant (1), **caractérisé en ce que** l'on forme le revêtement (34) sur au moins une des faces principales (32, 33) d'une plaquette (31) et **en ce que** l'on grave la plaquette ainsi revêtue pour former la pièce (9 ; 10).

## Patentansprüche

1. Mikromechanisches oder Uhrenbauteil mit flexibler Führung, das erste und zweite starre Teile (2, 3) umfasst, die durch ein System mit elastischen Armen (7, 8) verbunden sind, das angeordnet ist, um eine Verschiebung des zweiten starren Teils (3) in Bezug zu dem ersten starren Teil (2) in einer bestimmten Ebene zu führen, **dadurch gekennzeichnet, dass** mindestens einer der elastischen Arme (7, 8) einen Kern (25) und eine Beschichtung (26) umfasst, die aus einem Material hergestellt ist, das ein Elastizitätsmodul aufweist, das höher ist als dasjenige des Materials, aus dem der Kern hergestellt ist, und dadurch, dass der Kern (25) die Beschichtung (26) nur auf seinen zwei Seiten (27, 28) oder einer seiner zwei Seiten (27, 28) trägt, die parallel zur bestimmten Ebene sind.

2. Bauteil nach Anspruch 1, **dadurch gekennzeichnet, dass** das Elastizitätsmodul des Materials, aus dem die Beschichtung hergestellt ist, mindestens zwei Mal größer ist als das Elastizitätsmodul des Materials, aus dem der Kern hergestellt ist.

3. Bauteil nach Anspruch 1 oder 2, **dadurch gekennzeichnet, dass** die Beschichtung (26) aus einem der folgenden Materialien hergestellt ist: Diamant, Carbid, Nitrid, Keramik, Cermet, amorpher Kohlenstoff.

4. Bauteil nach einem der Ansprüche 1 bis 3, **dadurch gekennzeichnet, dass** der Kern (25) aus einem der folgenden Materialien hergestellt ist: Metall, Metalllegierung, Silizium, metallisches Glas.

5. Bauteil nach einem der Ansprüche 1 bis 4, **dadurch gekennzeichnet, dass** die Dicke (e) der Beschichtung (26) zwischen 1 und 30 µm enthalten ist.

6. Bauteil nach einem der Ansprüche 1 bis 5, **dadurch gekennzeichnet, dass** die Beschichtung (26) auch auf mindestens einem der starren Teile (2, 3) vorhanden ist.

7. Bauteil nach Anspruch 6, **dadurch gekennzeichnet, dass** die Beschichtung (26) auf jedem elastischen Arm (7, 8) und auch auf jedem starren Teil (2, 3) vorhanden ist.

8. Bauteil nach einem der Ansprüche 1 bis 7, **dadurch gekennzeichnet, dass** die Verschiebung eine Drehung des zweiten starren Teils (3) in Bezug auf den ersten starren Teil (2) um eine virtuelle Drehachse (5) ist.

9. Bauteil nach Anspruch 8, **dadurch gekennzeichnet, dass** die elastischen Arme (7, 8) oder zumindest zwei davon sich kreuzen.

10. Bauteil nach Anspruch 8, **dadurch gekennzeichnet, dass** das System mit elastischen Armen einen RCC-Zapfen bildet.

11. Bauteil nach einem der Ansprüche 1 bis 7, **dadurch gekennzeichnet, dass** die Verschiebung eine Translation des zweiten starren Teils (3) in Bezug zu dem ersten starren Teil (2) ist.

12. Bauteil nach einem der Ansprüche 1 bis 11, **dadurch gekennzeichnet, dass** es eine Wippe, ein/en Hebel, ein/en Oszillator oder ein/en Hemmungsanker ist oder umfasst.

13. Verfahren zur Herstellung eines mikromechanischen oder Uhrenbauteils nach einem der Ansprüche 1 bis 12, **dadurch gekennzeichnet, dass** die Beschichtung (34) auf mindestens einer der Hauptseiten (32, 33) einer Platte (31) gebildet wird, und dadurch, dass die so beschichtete Platte graviert wird, um das Bauteil zu bilden.

14. Verfahren zur Herstellung eines Teils (9; 10), das dazu bestimmt ist, Teil eines mikromechanischen oder Uhrenbauteils (1) nach einem der Ansprüche 1 bis 12 zu sein, wobei das Teil (9; 10) mindestens einen der elastischen Arme (7, 8) des Bauteils (1) umfasst, **dadurch gekennzeichnet, dass** die Beschichtung (34) auf mindestens einer der Hauptseiten (32, 33) einer Platte (31) gebildet wird und dadurch, dass die so beschichtete Platte graviert wird, um das Teil (9; 10) zu bilden.

## Claims

1. Micromechanical or timepiece component with flexible guidance, comprising first and second rigid portions (2, 3) connected by a system having elastic arms (7, 8) arranged to guide movement of the second rigid portion (3) with respect to the first rigid portion (2) in a determined plane, **characterised in that** at least one of the elastic arms (7, 8) comprises a core (25) and a coating (26) made of a material having a modulus of elasticity greater than that of the material of which the core is made, and **in that** the core (25) bears the coating (26) only on its two faces (27, 28), or one of its two faces (27, 28), which are parallel to the determined plane.

2. Component as claimed in claim 1, **characterised in that** the modulus of elasticity of the material of which the coating is made is at least twice as great as the modulus of elasticity of the material of which the core is made.

3. Component as claimed in claim 1 or 2, **characterised in that** the coating (26) is made of one of the following materials: diamond, carbide, nitride, ceramic, cermet, amorphous carbon.

4. Component as claimed in any one of claims 1 to 3, **characterised in that** the core (25) is made of one of the following materials: metal, metal alloy, silicon, metallic glass.

5. Component as claimed in any one of claims 1 to 4, **characterised in that** the thickness (e) of the coating (26) is between 1 and 30 µm.

6. Component as claimed in any one of claims 1 to 5, **characterised in that** the coating (26) is also present on at least one of the rigid portions (2, 3).

7. Component as claimed in claim 6, **characterised in that** the coating (26) is present on each elastic arm (7, 8) and also on each rigid portion (2, 3).

8. Component as claimed in any one of claims 1 to 7, **characterised in that** said displacement is a rotation of the second rigid portion (3) with respect to the first rigid portion (2) about a virtual axis of rotation (5).

9. Component as claimed in claim 8, **characterised in that** the elastic arms (7, 8), or at least two of them, cross over each other.

10. Component as claimed in claim 8, **characterised in that** the system having elastic arms forms an RCC pivot.

11. Component as claimed in any one of claims 1 to 7, **characterised in that** said displacement is a translation of the second rigid portion (3) with respect to the first rigid portion (2).

12. Component as claimed in any one of claims 1 to 11, **characterised in that** it is, or comprises, a lever, a control, an oscillator or an escapement anchor.

13. Method of manufacturing a micromechanical or timepiece component as claimed in any one of claims 1 to 12, **characterised in that** the coating (34) is formed on at least one of the main faces (32, 33) of a plate (31), and **in that** the thus coated plate is etched to form the component.

14. Method of manufacturing a piece (9; 10) intended to form part of a micromechanical or timepiece component (1) as claimed in any one of claims 1 to 12, the piece (9; 10) comprising at least one of the elastic arms (7, 8) of the component (1), **characterised in that** the coating (34) is formed on at least one of the main faces (32, 33) of a plate (31), and **in that** the thus coated plate is etched to form the piece (9; 10).
